Europäisches Patentamt

European Patent Office

Office européen des brevets

(19)

(11) Numéro de publication: **0 210 087**
**B1**

(12) FASCICULE DE BREVET EUROPEEN

(45) Date de publication du fascicule du brevet:
31.01.90

(51) Int. Cl.⁴: **G01R 33/025**

(21) Numéro de dépôt: **86401295.0**

(22) Date de dépôt: **13.06.86**

(54) Procédé de mesure de l'aimantation induite dans un bâtiment naval, et dispositif de mise en oeuvre.

(30) Priorité: **14.06.85 FR 8509071**

(43) Date de publication de la demande:
**28.01.87 Bulletin 87/5**

(45) Mention de la délivrance du brevet:
**31.01.90 Bulletin 90/5**

(84) Etats contractants désignés:
**DE GB**

(56) Documents cités:
**EP-A- 0 133 408**
**DE-C- 977 836**
**FR-A- 1 172 659**

**PATENTS ABSTRACTS OF JAPAN,**
**vol. 7, no. 266 (P-239)[1411], 26 novembre 1983 & JP - A**
**- 58 147 662**
**PATENTS ABSTRACTS OF JAPAN,**
**vol. 7, no. 253 (P-235)[1398], 10 novembre 1983 & JP - A**
**- 58 135 975**

(73) Titulaire: **THOMSON-CSF, 51, Esplanade du Général de Gaulle, F-92800 Puteaux(FR)**

(72) Inventeur: **Dutholt, François, THOMSON-CSF**
**SCPI 19, avenue de Messine, F-75008 Paris(FR)**

(74) Mandataire: **Desperrier, Jean-Louis et al,**
**THOMSON-CSF SCPI, F-92045 PARIS LA DEFENSE**
**CEDEX 67(FR)**

## Description

La présente invention se rapporte à un procédé qui permet de mesurer l'aimantation induite dans un bâtiment naval afin de pouvoir mettre en oeuvre ensuite un procédé d'immunisation magnétique de ces mêmes bâtiments. Elle concerne également un dispositif qui permet de mettre en oeuvre ce procédé de mesure.

Actuellement la plupart des bâtiments navals, bateaux et sous-marins, sont fabriqués en acier ou en fer et s'aimantent donc d'une manière très importante. Cette aimantation comprend d'une part une partie permanente spécifique aux bâtiments et d'autre part une partie variable induite par le champ magnétique terrestre, et qui dépend donc de la position du bâtiment par rapport à celui-ci.

Cette aimantation du bâtiment vient se superposer au champ magnétique terrestre et entraîne donc une perturbation appelée "signature magnétique" du bâtiment. Cette perturbation permet de repérer le bâtiment et éventuellement de guider ou de mettre à feu des engins destinés à le détruire. Il est donc très important de minimiser, voire d'annuler, cette perturbation pour empêcher de détecter celui-ci par une méthode magnétique.

Cette opération, dite "immunisation magnétique", s'effectue de manière connue en créant dans le volume du bâtiment un champ magnétique qui vient contrecarrer celui du bâtiment afin d'annuler la signature magnétique.

Pour cela, on munit le bâtiment d'un ensemble de circuits appelés "boucles d'immunisation" qui sont parcourues par des courants électriques. Les dimensions et la disposition des boucles, ainsi que l'intensité des courants qui les parcourent, sont déterminées pour minimiser au mieux la signature de bâtiment magnétique quelle que soit son orientation dans le champ terrestre, c'est-à-dire quels que soient son cap et son inclinaison dus au roulis et au tangage. Ces boucles d'immunisation sont réparties selon trois ensembles correspondant aux axes de roulis, de tangage et de lacet et appelés de manière conventionnelle "L,M,A".

Pour déterminer les intensités des courants à faire passer dans les boucles d'immunisation, il faut mesurer la signature magnétique du bâtiment et on utilise pour cela une station de mesures magnétiques telle que décrite par exemple dans la demande de brevet européen EP-A 0 133 408.

Une telle station comporte avantageusement deux réseaux linéaires de capteurs magnétiques, appelés bases, placés sur le fond de la mer et alignés chacun selon une direction cardinale, N/S pour l'une, et E/O pour l'autre. Ces capteurs sont reliés à une unité de traitement à terre, qui reçoit les signaux produits par le passage du bâtiment à immuniser au-dessus des bases selon des trajectoires de préférence elles-mêmes cardinales. Ces signaux sont traités dans la station pour déterminer l'intensité et la polarité des courants dans les boucles d'immunisation de manière à obtenir une immunisation satisfaisante quelle que soit l'attitude du bâtiment dans le champ terrestre.

Comme l'aimantation permanente est fixe par rapport au navire en direction et amplitude et n'évolue que très lentement en fonction du temps, on peut déterminer une composante continue du courant dans chaque boucle dont la valeur sera fixe et éventuellement réajustée lors d'une opération d'immunisation ultérieure.

Par contre l'aimantation induite est variable et il est nécessaire de superposer à cette composante continue une composante variable déterminée selon le cap et l'attitude du bâtiment qui sont connus par des moyens de mesure, gyroscopiques ou optiques par exemple.

Pour déterminer respectivement ces composantes continues et variables, il faut lors de la mesure de la signature magnétique séparer les influences de l'aimantation permanente et de l'aimantation induite dans l'aimantation totale, et ceci dans les trois directions correspondant aux trois axes du bâtiment.

Pour cela, on fait généralement parcourir au bâtiment deux fois la même route au-dessus des bases selon des caps opposés. Le bâtiment passe ainsi selon une direction N/S au-dessus de la base E/O puis S/N au-dessus de cette même base. Il passe ensuite selon une direction E/O au-dessus de la base N/S et revient selon une direction O/E au-dessus de celle-ci. L'orientation des bases et des routes n'est pas obligatoire mais elle permet de faciliter l'interprétation des mesures et les calculs.

Au cours de ces passages opposés, l'aimantation permanente, qui est liée au bâtiment, tourne avec celui-ci, tandis que l'aimantation induite ne tourne pas. Pour connaître cette aimantation induite, il suffit donc de soustraire les deux mesures correspondant à deux passages selon des sens opposés. Connaissant alors l'aimantation induite et l'aimantation totale, on aura donc directement l'aimantation permanente.

En soi, le fait d'effectuer deux passages successifs suivant des caps opposés est un inconvénient, notamment parce qu'il allonge la durée des opérations. De plus, il est nécessaire de recaler les mesures, par exemple par interpolation, de façon à effectuer une soustraction sur des points homologues pour les deux passages. En effet il existe un écart inévitable entre les routes dans un sens et dans l'autre. Comme par ailleurs les mesures de trajectographie présentent elles-mêmes une certaine imprécision, on voit que l'on accumule ainsi les sources d'erreurs.

Enfin, cette méthode est limitée aux aimantations longitudinale et transversale, puisqu'il n'est évidemment pas possible de retourner le bâtiment afin de séparer l'aimantation induite de l'aimantation permanente selon la direction verticale. Dans ce dernier cas on sépare les deux aimantations selon des méthodes empiriques fondées sur l'expérience des opérateurs et des mesures sur des maquettes grossièrement représentatives du bâtiment.

Pour pallier ces inconvénients, l'invention propose un procédé de mesure conforme à la revendication 1.

D'autres particularités et avantages de l'invention apparaîtront clairement dans la description suivante présentée à titre d'exemple non limitatif en regard des figures annexées qui représentent:

la figure 1, une vue schématique d'un bâtiment muni de boucles d'immunisation;
la figure 2, le schéma d'alimentation de ces boucles;
la figure 3, le schéma du système de mesure;
la figure 4, le diagramme des signaux représentant les variations de l'aimantation induite avec le déplacement du bâtiment.

Pour faciliter l'explication, la description suivante concerne l'axe longitudinal du bâtiment, mais le procédé est le même pour l'axe transversal et l'axe vertical, l'invention étant particulièrement utile pour ce dernier.

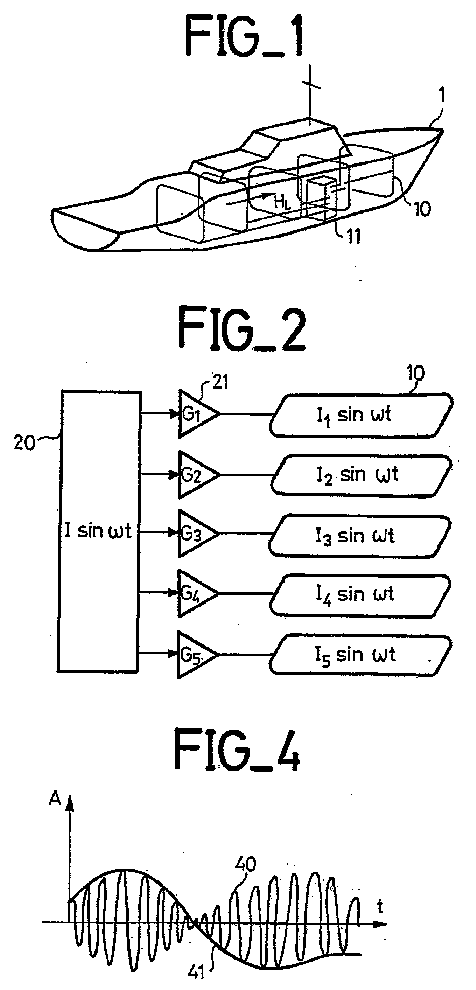

Le bâtiment de surface 1 représenteé sur la figure 1 est muni par exemple de 5 boucles 10 d'immunisation (L) permettant de compenser l'aimantation longitudinale. Le dimensionnement et le positionnement de ces boucles ont été déterminés à priori par des procédés empiriques basés sur l'expérience précédente et qui sont généralement suffisants, la précision du système d'immunisation reposant essentiellement sur la détermination précise des courants à faire circuler dans ces boucles. Elles produisent un champ longitudinal $H_L$ dont les lignes de champ sont semblables à celles d'un solénoïde.

Selon l'invention, il faut faire parcourir ces boucles par un courant alternatif produisant un champ magnétique qui soit, compte non tenu de l'influence magnétique du bâtiment, aussi proche que possible du champ terrestre c'est-à-dire le plus homogène possible. Un tel champ est parfaitement calculable par l'application des lois de l'électromagnétisme, notamment celles de Biot et Savart. On calcule donc ce champ en fonction des différents courants en un ensemble de points répartis dans le volume du bâtiment, notamment aux endroits où le risque de fortes aimantations induites est le plus grand, c'est-à-dire là où les masses métalliques sont les plus importantes. On détermine ainsi les courants dans les boucles afin de minimiser les écarts entre les valeurs du champ en ces points et une valeur de champ donnée, en utilisant par exemple la méthode des moindres carrés.

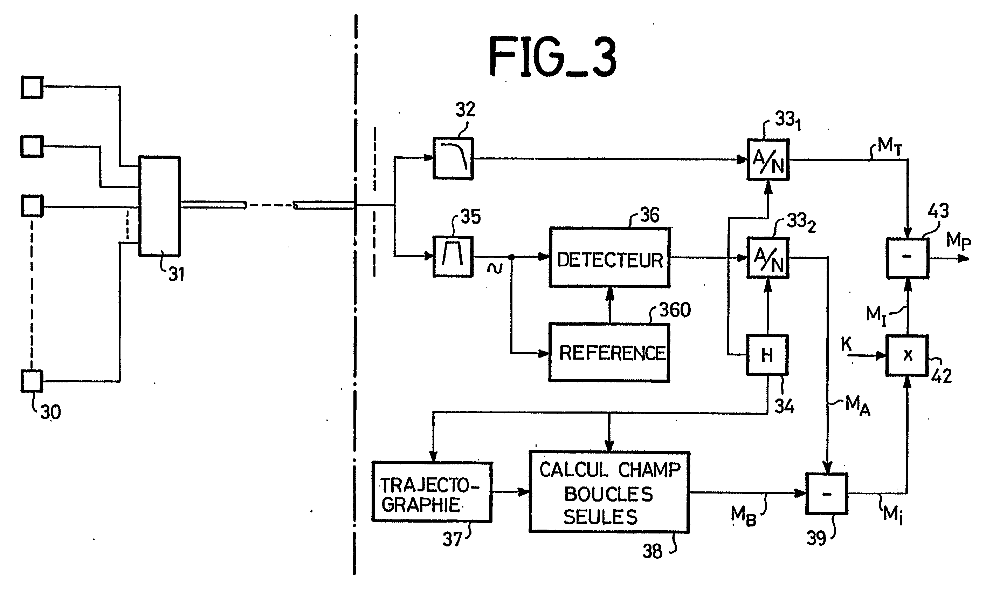

Selon l'invention, le bâtiment 1 comporte des moyens 11 permettant d'alimenter les boucles 10 par des courants alternatifs dont les intensités correspondent à celles ainsi calculées. Ces moyens comprennent par exemple comme sur la figure 2 un générateur de courant alternatif 20 de pulsation ω qui alimente les boucles 10 par l'intermédiaire d'un ensemble d'amplificateurs de puissance 21, dont les phases sont identiques et dont les gains G sont réglés pour obtenir les intensités voulues.

La fréquence du générateur 20 est assez faible, quelques Hertz par exemple, pour rendre negligeable le courant induit par mutuelle inductance entre les boucles, qui peuvent donc être considérées commme indépendantes.

Les amplitudes des courants sont choisies pour obtenir sur les capteurs immergés un niveau de champ magnétique suffisant pour une bonne détection, sans toutefois dépasser la partie linéaire du cycle d'hysteresis des parties métalliques du bâtiment.

Lorsque le bâtiment passe, les boucles 10 étant alimentées à partir du générateur 20, au-dessus d'une base formée des capteurs magnétiques 30 représentés sur la figure 3, ceux-ci délivrent des signaux de mesure comprenant une composante alternative superposée à une composante continue.

Ces signaux sont dirigés par l'intermédiaire d'une boîte de jonction 31 et d'un câble multi-filaire vers la station de mesure située à terre, dont on n'a représenté sur la figure 3 que les circuits correspondant à l'exploitation des signaux d'un seul des capteur 30. De plus, chaque capteur comprend généralement trois sondes dirigées selon trois axes rectangulaires afin de mesurer les composantes du champ magnétique selon ces mêmes axes, et on n'a représenté que les circuits correspondant à l'une de ces sondes. Enfin, chaque sonde comprend généralement un préamplificateur et un filtre passe-bas.

Le signal d'un capteur est donc traité tout d'abord dans un premier canal permettant de mesurer la signature continue, c'est-à-dire celle qui serait normalement mesurée en l'absence du champ alternatif. Celle-ci comprend à la fois la partie permanente et la partie induite par le champ terrestre.

Pour cela, on filtre le signal dans un filtre passe-bas 32 dont la fréquence de coupure est inférieure à la fréquence du champ alternatif reçu. Le signal continu ainsi obtenu est numérisé dans un convertisseur analogique numérique $33_1$ piloté par une horloge 34.

Le signal provenant du capteur est également traité dans un deuxième canal permettant d'isoler à l'aide d'un filtre passe-bande 35 la signature alternative produite par le courant alternatif passant dans les boucles 10. Le signal alternatif ainsi obtenu est détecté dans un détecteur 36 qui délivre son enveloppe, laquelle représente la somme de la signature due au champ induit dans le bâtiment par le courant passant dans les boucles 10 d'une part, et de la signature due au champ produit par les boucles seules d'autre part.

Le signal délivré par le détecteur 36 est numérisé dans un convertisseur analogique-numérique $33_2$ sous la commande du signal d'horloge provenant du circuit 34. On obtient ainsi le signal $M_A$ qui représente la somme de la signature induite alternative $M_i$ et de la signature des boucles seules $M_B$.

Cette dernière est obtenue par un calcul du champ magnétique au niveau des capteurs mis en oeuvre dans un calculateur 38 synchronisé par le circuit d'horloge 34. Ce calculateur fonctionne à partir des données qu'il contient et qui sont la forme des bobines et les courants qui les parcourent, la position des capteurs et la position du navire par rapport à la base 30, qui lui sont adressées par des moyens de trajectographie 37, de type connu, eux-mêmes synchronisés par l'horloge 34.

Selon une variante de l'invention, ces calculs sont effectués à l'avance pour la route prévue par le bâtiment et pour la hauteur d'eau correspondant au-dessus de la base, et mémorisés dans une mémoire adéquate. Le calculateur 38 ne sert alors qu'à recaler, par interpolation par exemple, les valeurs ainsi mémorisées en fonction de la route réelle suivie par le bâtiment.

Un soustracteur 39 permet de soustraire le signal $M_B$, correspondant aux boucles seules, au signal $M_A$ correspondant à la signature alternative, et de délivrer le signal $M_i$ représentant la signature induite correspondant au courant parcourant les boucles.

Ces courants ayant été déterminés pour représenter au champ magnétique homogène de valeur connue, on connaît le coefficient K correspondant au rapport entre la valeur de la composante du champ magnétique terrestre selon la direction étudiée longitudinale, et le champ induit dû aux boucles (10). Un circuit multiplicateur 40 permet de multiplier le signal $M_i$ par ce coefficient K pour obtenir la signature magnétique induite $M_I$ par la composante longitudinale du champ terrestre.

Comme on dispose, en sortie du convertisseur $33_1$, du signal $M_T$ donnant la valeur de la signature magnétique continue, un soustracteur 43 permet, à partir de $M_T$ et $M_I$, d'obtenir un signal $M_P$ représentant la signature magnétique permanente du bâtiment selon la direction longitudinale.

Le figure 4 représente l'allure du champ magnétique avant détection (40) et après détection (41) dans le cas où il y a inversion de la polarité du champ magnétique.

A titre de variante de réalisation, on peut mémoriser les signaux $M_A$ et $M_T$ ainsi que les données de trajectographie du bâtiment. Ceci permet d'effectuer les calculs nécessaires à la séparation entre le champ induit et le champ permanent en temps différé, et donc de se libérer des contraintes dues au temps de calcul.

De manière pratique, une fréquence du courant alternatif dans les boucles d'immunisation de 6 Hertz, associée à une largeur de bande des filtres 35 de 1 Hertz, donne de bons résultats.

Il est nécessaire d'effectuer la séparation des aimantations induite et permanente dans les trois directions, afin de pouvoir déterminer les courants à faire circuler dans les boucles M, L, A. Pour cela on peut de manière simple faire effectuer au bâtiment trois passages successifs sur une base, au cours desquels on injecte le courant alternatif respectivement dans les boucles M, L, A. Ceci permet d'obtenir les composantes verticale, longitudinale et transversale de l'aimantation induite.

A titre de variante, on peut alimenter simultanément les boucles M, L, A par des courants alternatifs à trois fréquences distinctes selon ces boucles. Ces fréquences sont choisies pour pouvoir être séparées aisément par filtrage, tout en étant assez basses pour rester dans la bande-passante des capteurs magnétiques. On peut alors séparer les composantes longitudinale, verticale et transversale de l'aimantation induite en un seul passage au-dessus de la base, mais il faut traiter le signal de chaque capteur dans quatre canaux, un pour le signal continu et trois pour les trois signaux alternatifs correspondant aux trois fréquences distinctes.

Une autre technique consiste à dédoubler les capteurs de la base, en utilisant à chaque fois simultanément pour la même direction, un capteur pour la détection de la signature continue, et un autre pour la détection de la signature alternative. Dans ces conditions, le capteur spécialisé pour la détection du champ alternatif pourra être sensible à des fréquences bien plus hautes que dans la version initiale et les conditions de réception, essentiellement le rapport signal sur bruit, seront fortement améliorées.

## Revendications

1. Procédé de mesure de l'aimantation induite dans un bâtiment naval (1) muni d'au moins un ensemble de boucles d'immunisation (10) destinées à être parcourues par des courants permettant de neutraliser l'aimantation de ce bâtiment (1), du type où l'on fait passer le bâtiment au-dessus d'au moins une base de mesure comportant au moins un capteur (30) de champ magnétique et où l'on détermine la signature magnétique du bâtiment à partir des signaux délivrés par ce capteur (30), caractérisé en ce que l'on alimente les boucles d'immunisation (10) par des courants alternatifs de même fréquence et de même phase dont les intensités sont calculées pour créer un champ inducteur alternatif homogène de valeur déterminée, que l'on détermine la trajectoire du bâtiment (1) par rapport au capteur (30) pour calculer la valeur du champ inducteur au niveau de ce capteur (30), que l'on isole par filtrage passe-bande (35) dans le signal provenant du capteur (30) la composante alternative produite par le courant alternatif passant dans les boucles (10), que l'on détecte cette composante alternative et qu'on soustrait ensuite sa valeur du champ inducteur calculé au niveau du capteur (30) pour obtenir la valeur du champ dû au champ induit par le champ inducteur, et que l'on multiplie cette valeur due au champ induit par un coefficient k de proportionnalité entre la valeur du champ terrestre et la valeur du champ inducteur pour obtenir l'aimantation induite par le champ terrestre.

2. Procédé selon la revendication 1, caractérié en ce que le capteur (30) permet de détecter les signaux continus et alternatifs à basse fréquence, et que l'on sépare dans les signaux délivrés par ce capteur par filtrage passe-bas (32) une composante continue correspondant à l'aimantation permanente du bâtiment (1), et par filtrage passe-bande (35) la composante alternative correspondant au champ inducteur et à l'aimantation induite.

3. Procédé selon la revendication 1, caractérisé en ce que le capteur (30) comprend un premier élément permettant de détecter les signaux continus et basse fréquence en-dessous d'une fréquence de coupure inférieure à la fréquence déterminée, et un deuxième élément permettant de détecter les signaux alternatifs dans une bande de fréquence située au-dessus de la fréquence de coupure et comprenant la fréquence déterminée; le premier élément délivrant une composante continue correspondant à l'aimantation permanente et le deuxième élément délivrant une composante alternative correspondant au champ inducteur et à l'aimantation induite.

4. Procédé selon la revendication 2, caractérisé en ce que l'on effectue la somme de l'aimantation permanente et de l'aimantation induite pour obtenir la signature magnétique du bâtiment (1).

5. Procédé selon l'une quelconque des revendications 1 à 4, caractérisé en ce que, le bâtiment (1) comprenant trois ensembles de boucles d'immunisation correspondant aux directions longitudinale, transversale et verticale du bâtiment (1), on fait passer celui-ci trois fois de suite au-dessus de la base de mesure en alimentant à chaque fois un ensemble distinct de boucles d'immunisation pour déterminer successivement les composantes de l'aimantation induite correspondant à chacune des trois directions.

6. Procédé selon l'une quelconque des revendications 1 à 4, caractérisé en ce que, le bâtiment (1) étant muni de trois ensembles de boucles d'immunisation (10) correspondant aux directions longitudinale, transversale et verticale du bâtiment (1), on alimente chacun de ces ensembles par trois ensembles de courants alternatifs ayant chacun une fréquence distincte, que l'on fait passer une seule fois le bâtiment au-dessus de la base et que l'on sépare dans les signaux issus du capteur (30) ces trois fréquences afin de déterminer simultanément les trois composantes de l'aimantation induite selon les trois directions du bâtiment.

7. Procédé selon l'une quelconque des revendications 1 à 6, caractérisé en ce que l'on enregistre les signaux de mesure et les données de trajectographie, et que l'on effectue les calculs en temps différé.

8. Base de mesure pour la mise en œuvre du procédé selon l'une quelconque des revendications 1 à 7, comprenant au moins un capteur (30) pour mesurer le champ perturbé par le navire, caractérisée en ce qu'elle comprend en outre des moyens (32) pour isoler dans les signaux du capteur une composante continue, des moyens (35) pour isoler dans les signaux du capteur une composante alternative, des moyens de détection synchrone (36, 360) pour détecter cette composante continue, des moyens (37) pour déterminer la route suivie par le bâtiment (1), des moyens (38) pour déterminer le champ inducteur produit par les courants dans les boucles au niveau du capteur, des moyens pour soustraire (39) au signal détecté le signal délivré par les moyens de détermination du champ inducteur, des moyens (42) pour multiplier le signal provenant des moyens de soustraction par un coefficient k de proportionnalité entre la valeur du champ inducteur et le champ terrestre et délivrer un signal donnant la valeur de l'aimantation induite.

9. Base de mesure selon la revendication 8, caractérisée en ce que chaque capteur (30) de champ magnétique est dédoublé et comprend une partie sensible au champ continu et une partie sensible au champ alternatif.

## Claims

1. A method for measuring the induced magnetization in a marine vessel (1) equipped with at least one set of degaussing loops (10) intended for being traversed by electric currents in order to neutralize the magnetization of the vessel (1), the method being of the type wherein the vessel is made to pass over at least one measurement basis, which comprises at least one magnetic field probe (30) and the magnetic "imprint" of the vessel is determined from the signals delivered by said probe (30), characterized in that the degaussing loops (10) are fed by alternating current having the same frequency and the same phase, whose intensities are computed in order to generate a homogeneous alternating inductor field having a predetermined strength, that the trajectory of the vessel (1) is determined relative to the probe (30) in order to compute the strength of the inductor field near the probe (30), that in the signal provided by the probe (30), the alternating component produced by the alternating current flowing in the loops (10) is isolated by band pass filtering (35), that this alternating component is detected and that it is subsequently subtracted from the calculated inductor field near the probe (30) in order to obtain the strength of the field due to the field induced by the inductor field, and that this quantity due to the inducing field is multiplied by a factor of proportionality k beween the strength of the terrestrial field and the stength of the inductor field, in order to obtain the magnetization induced by the terrestrial field.

2. A method according to claim 1, characterized in that the probe (30) allows to detect the continuous and low frequency alternating signals, and that the continuous component corresponding to the permanent magnetization of the vessel (1) is separated from the signals delivered by the probe by means of a low-pass filtering (32), whereas the alternating component corresponding to the inductor field and the induced magnetization is separated by means of a pass-band filtering (35).

3. A method according to claim 1, characterized in that the probe (30) includes a first element intended to detect the continuous and low frequency signals below a cut-off frequency which in turn is smaller than the predetermined frequency, and a second element intended to detect the alternating signals existing in a frequency band situated above the cut-off frequency and including the predetermined frequency, the first element delivering a continuous component corresponding to the permanent magnetization, whereas the second element delivers an alternative component corresponding to the inductor field and to the induced magnetization.

4. A method according to claim 2, characterized in that in order to obtain the magnetic imprint of the vessel (1), the sum of the permanent magnetization and of the induced magnetization is formed.

5. A method according to anyone of claims 1 to 4, characterized in that the vessel (1) comprises three sets of degaussing loops corresponding to the longitudinal, transversal and vertical directions of the vessel (1), that the vessel is made to pass three times in succession above the measurement basis, thereby feeding each time a distinct set of the degaussing loops with power in order to determine successively the components of the induced magnetization corresponding to each of the three directions.

6. A method according to anyone of the claims 1 to 4, characterized in that, the vessel (1) being equipped with three sets of degaussing loops (10) corresponding to the longitudinal, transversal and vertical directions of the vessel (1), each of the sets is fed with three sets of alternating currents each having a distinct frequency, that the vessel is made to pass only once above the measurement basis, and that the three frequencies are separated from the signals delivered by the probe (30) in order to determine simultaneously the three components of the induced magnetization in accordance with the three directions of the vessel.

7. A method according to anyone of the claims 1 to 6, characterized in that the measurement signal and the trajectory data are recorded, and that the computations are carried out later on.

8. A measurement basis for implementing the method according to anyone of the claims 1 to 7, comprising at least one probe (30) for measuring the magnetic field as distorted by the vessel, characterized in that it includes in addition means (32) for isolating a continuous component contained in the probe signals, means (35) for isolating an alternating component contained in the probe signals, synchronous detection means (36, 360) for detecting said continuous component, means (37) for determining the path followed by the vessel (1), means (38) for determining the inductor field produced by the currents in the loops near the probe, means (39) for subtracting the signal delivered by the means for determining the inductor field, means (42) for multiplying the signal from the subtracting means with a proportionality factor k between the strength of the inductor field and the terrestrial field and for delivering a signal giving the strength of the induced magnetization.

9. A measurement basis according to claim 8, characterized in that each magnetic field probe (30) exists twice, and comprises a portion which is sensitive to the continuous field, and a portion which is sensitive to the alternating field.

**Patentansprüche**

1. Verfahren zur Messung der in ein Seefahrzeug (1) induzierten Magnetisierung, wobei dieses Seefahrzeug mit mindestens einem Satz von Entmagnetisierungsschleifen (10) ausgestattet ist, durch welche Ströme zur Neutralisierung der Magnetisierung des Fahrzeuges (1) hindurchgeleitet werden und wobei das Verfahren so gestaltet ist, daß das Fahrzeug über mindestens eine Meßbasis mit mindestens einer Magnetfeldsonde (30) fährt und die magnetische Charakteristik des Fahrzeuges aus den von der Sonde gelieferten Signalen bestimmt wird, dadurch gekennzeichnet, daß die Entmagnetisierungsschleifen mit Wechselströmen gleicher Frequenz und gleicher Phase gespeist werden, deren Stärke so berechnet ist, daß sie ein homogenes Induktor-Wechselfeld bestimmter Größe erzeugen, daß der Fahrweg des Fahrzeugs (1) bezüglich der Sonde (30) so bestimmt wird, daß der Wert des Induktorfelds in Höhe dieser Sonde (30) berechnet wird, daß mit Hilfe eines Bandpaßfilters (35) aus dem von der Sonde (30) kommenden Signal die vom durch die Schleifen (10) fließenden Wechselstrom erzeugte Wechselstromkomponente abgetrennt wird, daß diese Wechselstromkomponente erfaßt und ihre Größe anschließend von dem in Höhe der Sonde (30) berechneten Induktorfeld zur Ermittlung der Stärke des durch das Induktorfeld induzierten Feldes abzieht, und daß dieser durch das induzierte Feld bewirkte Wert zur Ermittlung der durch das Erdfeld induzierten Magnetisierung mit einem Proportionalitätsfaktor k zwischen dem Wert des Erdfeldes und dem Wert des Induktorfeldes multipliziert wird.

2. Verfahren nach Anspruch 1, dadurch gekennzeichnet, daß die Sonde (30) es gestattet, die Gleichspannungs- und niederfrequenten Wechselspannungssignale zu erfassen, und daß aus den von der Sonde gelieferten Signalen durch einen Tiefpaßfilter (32) eine Gleichkomponente entsprechend der permanenten Magnetisierung des Fahrzeuges (1), und durch ein Bandpaßfilter (35) die Wechselkomponente entsprechend dem Induktorfeld und der induzierten Magnetisierung abgetrennt wird.

3. Verfahren nach Anspruch 1, dadurch gekennzeichnet, daß die Sonde (30) ein erstes Element zur Erfassung der Gleichspannungs- und der niederfrequenten Signale unterhalb einer Grenzfrequenz, die niedriger als die festgesetzte Frequenz ist, und ein zweites Element zur Erfassung der Wechselspannungssignale in einem Frequenzband oberhalb der Grenzfrequenz unter Einschluß der festgesetzten Frequenz aufweist, wobei das erste Element eine Gleichkomponente entsprechend der permanenten Magnetisierung und das zweite Element eine Wechselkomponente entsprechend dem Induktorfeld und der induzierten Magnetisierung liefert.

4. Verfahren nach Anspruch 2, dadurch gekennzeichnet, daß zur Gewinnung der magnetischen Charakteristik des Fahrzeuges (1) die Summe der permanenten Magnetisierung und der induzierten Magnetisierung gebildet wird.

5. Verfahren nach einem beliebigen der Ansprüche 1 bis 4, dadurch gekennzeichnet, daß man das Fahrzeug (1), das drei Sätze von Entmagnetisierungsschleifen entsprechend der Längs-, Quer- und Tiefenrichtung des Fahrzeuges besitzt, dreimal hintereinander über die Meßbasis fahren läßt, wobei jedesmal ein bestimmter Satz von Entmagnetisierungsschleifen mit Strom gespeist wird, um nacheinander die Komponenten der induzierten Magnetisierung entsprechend jeder der drei Richtungen bestimmen zu können.

6. Verfahren nach einem beliebigen der Ansprüche 1 bis 4, dadurch gekennzeichnet, daß man bei dem Fahrzeug (1), das drei Sätze von Entmagnetisierungsschleifen entsprechend der Längs-, Quer- und Tiefenrichtung des Fahrzeuges besitzt, jeden der drei Schleifensätze mit drei Sätzen von Wechselströmen jeweils bestimmter Frequenz speist, daß man das Fahrzeug ein einziges mal über die Meßbasis fahren läßt, und daß man bei den von der Sonde (30) gelieferten Signalen die drei Frequenzen trennt, um gleichzeitig die drei Komponenten der induzierten Magnetisierung entsprechend der drei Richtungen des Fahrzeugs bestimmen zu können.

7. Verfahren nach einem beliebigen der Ansprüche 1 bis 6, dadurch gekennzeichnet, daß die Meßsignale und die trajektographischen Daten aufgezeichnet werden und daß die Berechnungen später erfolgen.

8. Meßbasis zur Durchführung des Verfahrens nach einem beliebigen der Ansprüche 1 bis 7, mit mindestens einer Sonde (30) zum Messen des durch das Schiff gestörten Magnetfeldes, dadurch gekennzeichnet, daß die Basis weiter Mittel (32) zum Aussondern einer Gleichkomponente aus den Sondensignalen, Mittel (35) zum Abtrennen einer Wechselkomponente aus den Sondensignalen, Synchrondetektormittel (36, 360) zum Erfassen dieser Gleichkomponente, Mittel (37) zum Bestimmen der vom Fahrzeug (1) verfolgten Bahn, Mittel (38) zum Bestimmen des von den Strömen in den Schleifen in Höhe der Sonde erzeugten Induktorfeldes, Mittel (39) zum Subtrahieren des von den Mitteln zur Bestimmung des Induktorfeldes gelieferten Signals von dem erfaßten Signal und Mittel (42) zum Multiplizieren des von den Subtraktionsmitteln gelieferten Signals mit einem Proportionalitätsfaktor k zwischen dem Wert des Induktorfeldes und des Erdfeldes und zum Liefern eines dem Wert der induzierten Magnetisierung wiedergebenden Signals aufweist.

9. Meßbasis nach Anspruch 8, dadurch gekennzeichnet, daß jede Magnetfeldsonde (30) doppelt vorhanden ist und einen für das Gleichfeld empfänglichen Abschnitt und einen für das Wechselfeld empfänglichen Abschnitt aufweist.

# FIG_1

# FIG_2

# FIG_4

FIG_3